# EUROPEAN PATENT APPLICATION

(11) **EP 1 100 112 A1**
(43) Date of publication of application: **16.05.2001**
(21) Application number: 99122582.2
(22) Date of filing: 12.11.1999
(51) Int. Cl.: H01J 49/46, H01J 49/48, G01R 31/305

(54) **Spectrometer objective for particle beam measuring system**

(71) Applicant: Advantest Corporation, Tokyo 163-08 (JP)
(72) Inventor: Kintaka, Akira, Kitamoto, Saitama (JP); Seyama, Masahiro, Iruma-gun, Saitama 350-0445 (JP); Frosien, Jürgen, Dr., 85521 Riemerling (DE)
(74) Representative: Tetzner, Michael, Dipl.-Ing.

(57) **Abstract**

Spectrometer objective for a particle beam measuring system with an objective lens and a retarding field spectrometer which form a particle beam optical unit for focussing a primary particle beam, wherein the retarding field spectrometer comprises an extraction electrode arrangement for extracting secondary particles from a specimen, an acceleration electrode arrangement for accelerating the secondary particles in the direction of the objective lens, a retarding field electrode arrangement for establishing a potential barrier which retards the secondary particles and means for charging the first electrode arrangement with at least two different voltages for adjustment of the extraction field strength. Furthermore, there are means for charging the acceleration electrode arrangement dependent on the voltage of the extraction electrode arrangement to form a secondary particle bundle being adapted for passing the retarding field electrode arrangement.

## Description

The present invention is directed to a spectrometer objective for a particle beam measuring system with an objective lens and a retarding field spectrometer which form a particle beam optical unit for focussing a primary particle beam.

A spectrometer objective is known from U.S. patent 4,728,790. The disclosed spectrometer objective is essentially composed of a magnetic objective lens having a short focal length, a deflection unit arranged within the objective lens and an retarding field spectrometer which together form the components of an electron-optical column of an electron beam measuring instrument. The disclosed objective lens is used to focus both the primary electrons emitted by a high-current electron source, as well as secondary electrons generated at a specimen by the primary electrons. The secondary electrons are focussed by the objective lens to a point lying along the optical axis of the measuring instrument.

The focus of the secondary electrons which have been accelerated to high kinetic energies lies in the center of a spherically symmetrical retarding field that is generated by a portion of the spectrometer disposed above the objective lens. The spherically symmetrical retarding field is generated with the assistance of an appropriately formed electrode pair.

To guarantee good focussing of the secondary electrons, one is forced to provide a high positive potential to the extraction electrode disposed immediately above the specimen. High extraction fields (E = 1 - 2 kV) in the region of the specimen, however, should be avoided, particularly when checking the operation of passivated micro-electronic components. In addition, the uniformity of the extraction field is disturbed particularly for highly structured specimens and this has an unfavourable effect on the resolution of the electron beam measuring instrument, which is determined by the diameter of the electron probe on the specimen. Accordingly, U.S. patent 4,812,651 suggests to include an extraction electrode in the path of the primary particle beam disposed immediately above the specimen and being charged with a variable voltage in order to adjust the extraction field strength.

The additional extraction electrode allows to realize high extraction fields as well as low extraction fields (i.e. for passivated circuits). Accordingly, the extraction electrode is applied with high voltages of several kV (typically 1 kV) or lower voltages around 0 V (typically - 50 V to + 100 V).

However, this spectrometer objective using an additional electrode immediately above the specimen has the disadvantage that the secondary electron crossover is not within the region of the center of the spherically symmetrical retarding field that is generated by a portion of the spectrometer disposed above the objective lens and, as a consequence, the measuring results are inaccurate.

Accordingly, an object of the present invention is to provide a spectrometer objective according to the preamble to claim 1 which improves the measuring results also for applications using low extraction fields.

The objective is solved by the features of claim 1.

Further embodiments of the invention are the subject matter of the subordinate claims.

The spectrometer objective for a particle beam measuring instrument according to the invention has an objective lens and a retarding field spectrometer which form a particle beam optical unit for focussing a primary particle beam, wherein the retarding field spectrometer comprises:
- an extraction electrode arrangement for extracting secondary particles from the specimen,
- an acceleration electrode arrangement for accelerating the secondary particles in the direction of the objective lens,
- a retarding field electrode arrangement for establishing a potential barrier which retards the secondary particles and
- means for charging the extraction electrode arrangement with at least two different voltages for adjustment of the extraction field strength.

Furthermore, there are provided means for charging the acceleration electrode arrangement dependent on the voltage of the extraction electrode arrangement to form a secondary particle bundle being adapted for passing the retarding field electrode arrangement.

By adapting the voltage of the acceleration electrode arrangement in accordance with a change of the voltage of the extraction electrode arrangement, it is possible to improve the measuring results, especially in the case of a low extraction voltage.

In a preferred embodiment, the voltage of the acceleration electrode arrangement is adapted to the extraction electrode arrangement in that the secondary particle crossover lies in the region of the center of the retarding field electrode arrangement.

In a further improvement, the means for charging the extraction and acceleration electrode arrangements are controlled by switching means having at least two modes, in which the extraction and acceleration electrode arrangements are applied with preset voltage values.

Further embodiments of the invention will be described hereafter with reference to the drawings.

In the drawings
- Fig. 1: is a vertical cross-section of an embodiment of an spectrometer objective of the invention,
- Fig.2: is a partial cross-section of the spectrometer objective of Fig.1 with a high extraction field and
- Fig.3: is a partial cross-section of the spectrometer objective of Fig.1 with a low extraction field.

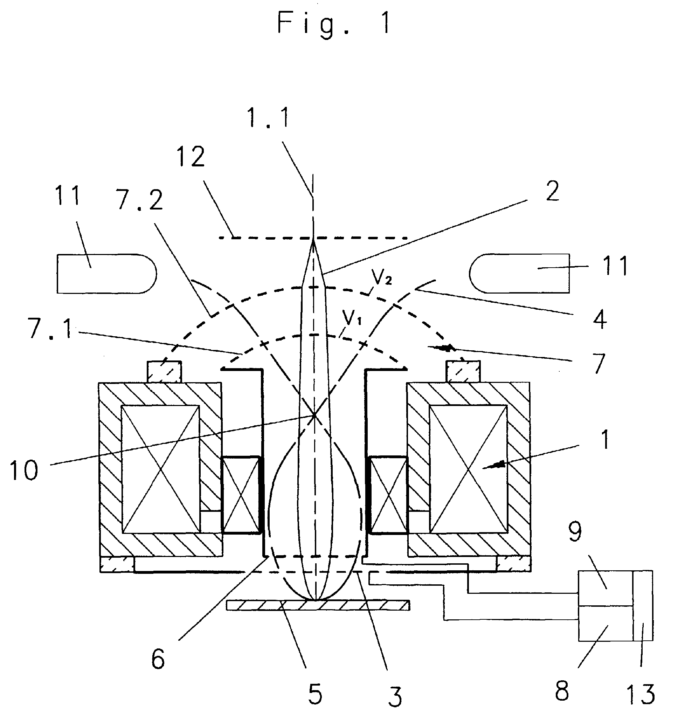

A spectrometer objective according to one embodiment of the invention is shown schematically in Fig.1, essentially having an objective lens 1 and a retarding field spectrometer which form a particle beam optical unit for focussing a primary particle beam 2.

The retarding field spectrometer comprises
- an extraction electrode arrangement 3 for extracting secondary particles 4 from a specimen 5,
- an acceleration electrode arrangement 6 for accelerating the secondary particles 4 in the direction of the objective lens 1
- and a retarding field 7 for establishing a potential barrier which retards the secondary particles 4.

Furthermore, there are means 8 for charging the extraction electrode arrangement 3 with at least two different voltages Vₑₓ for adjustment of the extraction field strength in the region of the specimen 5. Furthermore, means 9 are provided for charging the acceleration electrode arrangement 6 with a variable voltage V_{acc}. Charging means 9 are adapted for charging the acceleration electrode arrangement 6 dependent on the voltage Vₑₓ of the extraction electrode arrangement 3 to form a secondary particle bundle being adapted for passing the retarding field electrode arrangement 7.

The retarding field electrode arrangement 7, as enclosed, has a first and a second electrode 7.1, 7.2, whereby the first electrode 7.1 is part of the surface of a first sphere with a first radius and the second electrode is part of the surface of a second sphere with a second radius, the center points of the first and second spheres coinciding in a point centre 10 lying on the optical axis 1.1 of the objective lens 1. The first and second electrode 7.1, 7.2 are charged with voltages V₁, V₂, in that a potential barrier is established which retards the secondary particles 4.

For detecting the secondary particles penetrating the electrode 7.2, a detector 11 is provided. When using a symmetrical detector arrangement, an electrode 12 lying at a negative potential can also be provided above the first and second electrodes 7.1, 7.2. The electrode 12 deflects any secondary electrons 4 emitted in the direction of the optical axis 1.1.

The extraction electrode arrangement 3 is preferably formed of a planar grid electrode and is conductively connected to charging means 8.

The acceleration electrode arrangement 6 is formed according to this embodiment by a liner tube which is a hollow cylinder arranged concentrically about the optical axis 1.1. This liner tube avoids having the electrical fields within the objective lens 1 disturbe the movement of the secondary electrons 4.

The two electrodes 7.1 and 7.2 of the retarding field electrode arrangement 7 are formed by spherical grid electrodes. In the disclosed embodiment, the first electrode 7.1 is electrically connected to the end of the liner tube forming the acceleration electrode arrangement 6. Accordingly, the voltage V₁ of the first electrode 7.1 is identical with the voltage V_{acc} of the acceleration electrode arrangement 6 which is applied by charging means 9.

The electron beam measuring instrument provides a primary particle beam 2, for instance a primary electron beam, emitted by a beam generator which is focussed onto the specimen 5. The primary particles generate secondary particles on the specimen 5, and the secondary electrons are extracted from the specimen. The secondary electrons pass through the extraction electrode arrangement 3 and will be accelerated by the acceleration electron arrangement 6. They proceed into the magnetic field of the objective lens 1 so that they have a crossover on the optical axis 1.1. The crossover is to be interpreted as a real intermediate image of the virtual source of the secondary particles, in other words, the smallest caustic cross-section of all virtual secondary particle paths under the specimen 5. To achieve a good detection efficiency it is preferred to have the paths of the secondary electrons proceed parallel to the field lines of the retarding field electrode arrangement and, thus, perpendicular to the first and second electrodes 7.1, 7.2. This condition is true, if the crossover of the secondary particles lies in the center point 10 of the retarding field electrode arrangement 7.

The spherically-symmetrical electrical retarding field of the retarding field electrode arrangement 7 is used for the deceleration and energy analysis, the field being established in the spatial region between the two grid or grating electrodes 7.1, 7.2 lying at mutually different potentials V₁, V₂, respectively. The lower hemispherical grid electrode 7.1 lies at the potential V_{acc} of the acceleration electrode arrangement 6 and the upper hemispherical grid electrode 7.2 is generally charged with a potential of between approximately - 15 V and + 15 V.

Those secondary particles penetrating the upper hemispherical grid 7.2 will then be detected by detector 11.

The voltage Vₑₓ has to be adapted to the specimen to be tested.

Usually, the means 8 for charging the extraction electrode arrangement 3 is adapted to apply at least two voltages in the range of - 50 V to 2 kV. In the case of a passivated specimen, a low voltage will be used and in those cases, where a high extraction field will not charge the specimen, a higher voltage will be used.

Means 9 for charging the acceleration electrode arrangement 6 are adapted to apply at least two voltages in the range of + 500 V to 3 kV.

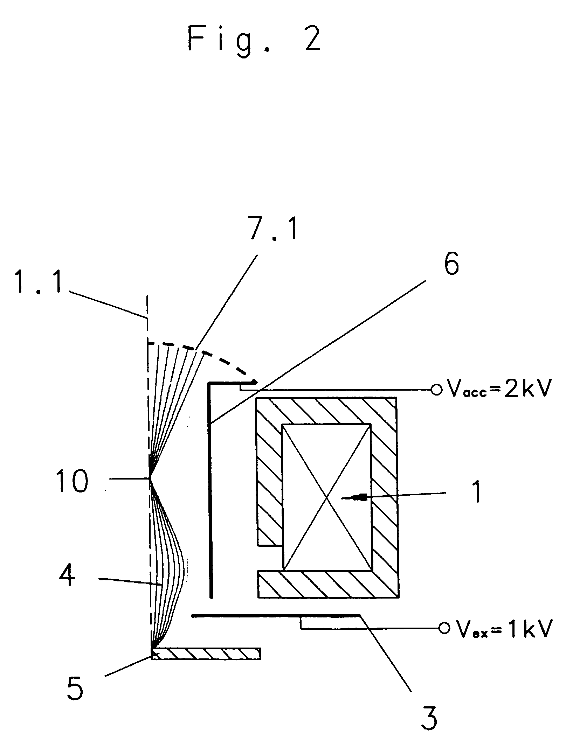

Fig.2 shows an embodiment where a voltage Vₑₓ of the extraction electrode arrangement is 1 kV and the voltage V_{acc} of the acceleration electrode arrangement is 2 kV. Accordingly, a high extraction field is generated in the region of the specimen 5. The secondary particles 4 have a crossover in the center point 10 of the retarding field electrode arrangement 7 which guarantees a good detection efficiency.

When testing passivated circuits, it is absolutely necessary to use low extraction voltages, in order to avoid charging of the specimen. To achieve a crossover on the optical axis 1.1, in this case it is necessary to adapt the acceleration voltage V_{acc} in accordance with the extraction voltage Vₑₓ. By using a suitable pair of voltages Vₑₓ, V_{acc} it will be possible to arrange the crossover of the secondary particles in the center point of the retarding field arrangement 7.

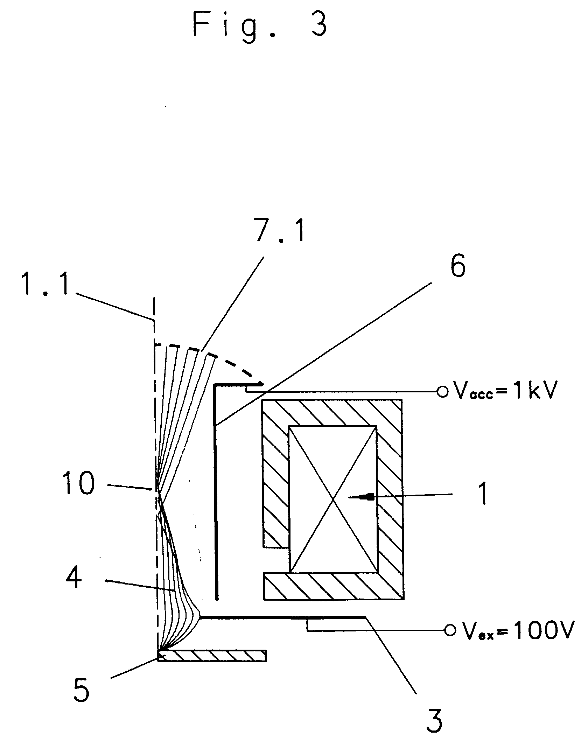

In the embodiment according to Fig.3, a low extraction field is generated by using an extraction voltage Vₑₓ of 100 V and an acceleration voltage V_{acc} = 1 kV.

In many cases, it will be sufficient, to have two modes, a first mode with a high extraction field and a second mode with a low extraction field. Accordingly, the means 8, 9 for charging the extraction and acceleration electrode arrangements are controlled preferably by switching means 13 (cf. Fig.1) having at least two modes in which the extraction and acceleration electrode arrangements are applied with preset voltage values. These voltages, for instance, can be set in a first mode to Vₑₓ = 1 kV and V_{acc} = 2 kV and in a second mode to Vₑₓ = 100 V and V_{acc} = 1 kV.

Such a spectrometer objective allows to adapt the extraction field to the specimen to be tested by pressing a button on the switching means. Irrespective of the mode used, accurate measuring results can be achieved.

## Claims

1. Spectrometer objective for a particle beam measuring system with an objective lens and a retarding field spectrometer which form a particle beam optical unit for focussing a primary particle beam (2), wherein the retarding field spectrometer comprises
- an extraction electrode arrangement (3) for extracting secondary particles (4) from a specimen (5),
- an acceleration electrode arrangement (6) for accelerating the secondary particles (4) in the direction of the objective lens (1),
- a retarding field electrode arrangement (7) for establishing a potential barrier which retards the secondary particles (4) and
- means (8) for charging the first electrode arrangement (3) with at least two different voltages (Vₑₓ) for adjustment of the extraction field strength,
characterised by means (9) for charging the acceleration electrode arrangement (6) dependent on the voltage (Vₑₓ) of the extraction electrode arrangement (3) to form a secondary particle bundle being adapted for passing the retarding field electrode arrangement (7).

2. Spectrometer objective as claimed in claim 1, characterised in that the acceleration electrode arrangement (6) is formed by a liner tube.

3. Spectrometer objective as claimed in claim 1, characterised in that the acceleration electrode arrangement (6) is formed by a liner tube which extends through the objective lens.

4. Spectrometer objective as claimed in claim 1, characterised in that the retarding field electrode arrangement (7) has a first and a second electrode (7.1, 7.2), whereby the first electrode (7.1) is part of the surface of a first sphere with a first radius and the second electrode (7.2) is part of the surface of a second sphere with a second radius, the centre points of the first and second spheres coinciding in a center point (10) lying on the optical axis (1.1) of the objective lens (1).

5. Spectrometer objective as claimed in claim 1, characterised in that the retarding field electrode arrangement (7) has a first and a second electrode (7.1, 7.2), whereby the first electrode (7.1) is part of the surface of a first sphere with a first radius and the second electrode (7.2) is part of the surface of a second sphere with a second radius, the centre points of the first and second spheres coinciding in a center point (10) lying on the optical axis (1.1) of the objective lens (1) and whereby the first electrode (7.1) is formed by the end of the acceleration electrode arrangement (6).

6. Spectrometer objective as claimed in claim 1, characterised in that the secondary corpuscle bundle has a crossover.

7. Spectrometer objective as claimed in claims 4 and 5, characterised in that the crossover lies in the region of the centre point (10) of the retarding field electrode arrangement (7).

8. Spectrometer objective as claimed in claim 1, characterised in that the means (8, 9) for charging the extraction and acceleration electrode arrangements (3, 6) are controlled by switching means (12) having at least two modes, in which the extraction and acceleration electrode arrangements are applied with preset voltage values (Vₑₓ, V_{acc}).

9. Spectrometer objective as claimed in claim 1, characterised in that the means (8) for charging the extraction electrode arrangement (3) is adapted to apply at least two voltages (Vₑₓ) in the range of - 50 V to 2 kV.

10. Spectrometer objective as claimed in claim 1, characterised in that the means (9) for charging the acceleration electrode arrangement (6) are adapted to apply at least two voltages (V_{acc}) in the range of + 500 V to 3 kV.
